(19) Europäisches Patentamt / European Patent Office / Office européen des brevets

(11) EP 4 737 924 A1

(12) EUROPEAN PATENT APPLICATION
published in accordance with Art. 153(4) EPC

(43) Date of publication:
06.05.2026 Bulletin 2026/19

(21) Application number: 24835027.4

(22) Date of filing: 10.01.2024

(51) International Patent Classification (IPC):
G01R 31/392 (2019.01)    G01R 31/36 (2020.01)

(52) Cooperative Patent Classification (CPC):
G01R 31/36; G01R 31/367; G01R 31/392

(86) International application number:
PCT/CN2024/071624

(87) International publication number:
WO 2025/007538 (09.01.2025 Gazette 2025/02)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 03.07.2023 CN 202310808644

(71) Applicants:
• Contemporary Amperex Future Energy Research
Institute (Shanghai) Limited
Shanghai 200241 (CN)
• Contemporary Amperex Technology Co., Limited
Ningde, Fujian 352100 (CN)

(72) Inventor: QIAN, Mu
Shanghai 200241 (CN)

(74) Representative: Gong, Jinping
CocreateIP
Neumarkter Straße 21
81673 München (DE)

(54) **BATTERY STATE-OF-HEALTH ESTIMATION METHOD, ELECTRONIC DEVICE AND COMPUTER-READABLE STORAGE MEDIUM**

(57) Embodiments of the present application provide a battery state of health estimation method, an electronic device, and a computer-readable storage medium. The battery state of health estimation method includes: obtaining historical operating condition data of a to-be-tested battery module; performing parameter identification on a battery parameter of the battery module based on the historical operating condition data to obtain an identification result; and predicting a state of health of a battery in the battery module based on the identification result. The above method can effectively improve the estimation accuracy of the battery state of health.

FIG. 1

# EP 4 737 924 A1

## Description

This application claims priority to Chinese Patent Application No. 202310808644.2, filed on July 3, 2023, at the China Patent Office, and entitled "BATTERY STATE OF HEALTH ESTIMATION METHOD, ELECTRONIC DEVICE, AND COMPUTER-READABLE STORAGE MEDIUM," which is incorporated herein by reference in its entirety.

## TECHNICAL FIELD

The present application relates to the field of batteries, and in particular, to a battery state of health estimation method, an electronic device, and a computer-readable storage medium.

## BACKGROUND

With the development of electric vehicles, the service life of batteries has gained increasing attention. Battery state of health (state of health, SOH), also referred to as a battery degradation coefficient, is used to reflect an aging degree and health degree of batteries. A higher SOH value indicates a lower aging degree and a higher health degree of batteries. A lower SOH value indicates a higher aging degree and lower health degree of batteries. However, related SOH value estimation methods typically exhibit low estimation accuracy, thereby affecting users' understanding of battery conditions.

## TECHNICAL PROBLEM

One of the objectives of embodiments of the present application is to provide a battery state of health estimation method, an electronic device, and a computer-readable storage medium, to address the issue of low estimation accuracy of the battery state of health.

## TECHNICAL SOLUTION

To address the foregoing technical problem, the technical solutions adopted in the embodiments of the present application are as follows.

According to a first aspect, a battery state of health estimation method is provided, including:

　　obtaining historical operating condition data of a to-be-tested battery module;
　　performing parameter identification on a battery parameter of the battery module based on the historical operating condition data to obtain an identification result; and
　　predicting a state of health of a battery in the battery module based on the identification result.

In the embodiments of the present application, performing parameter identification on the battery parameter based on the historical operating condition data of the battery module is equivalent to an offline identification approach. Compared with a real-time identification approach, the offline identification approach can avoid instability in identification results caused by recursive solving. Additionally, since parameter identification is conducted based on the historical operating condition data of the battery module, the battery parameter of the battery module can be accurately fitted, thereby effectively improving the estimation accuracy of the battery state of health.

In an implementation of the first aspect, the performing parameter identification on a battery parameter of the battery module based on the historical operating condition data to obtain an identification result includes:

　　obtaining a mathematical model of the battery module, where the mathematical model is constructed based on the battery parameter of the battery module; and
　　performing parameter identification on the battery parameter of the battery module based on the historical operating condition data and the mathematical model to obtain the identification result.

In the embodiments of the present application, parameter identification is performed in combination with the mathematical model to identify the parameter of the battery module, and then the state of health of the battery is predicted based on the identified parameter of the battery module. Since the mathematical model is constructed based on the battery parameter of the battery module, the mathematical model can accurately reflect the state of the battery module, providing a reliable model foundation for subsequent parameter identification. Additionally, the parameter identification method can provide accurate fitting of the battery parameter of the battery module. Combining the mathematical model and the parameter identification method can effectively improve the estimation accuracy of the battery state of health.

In an implementation of the first aspect, the performing parameter identification on the battery parameter of the battery module based on the historical operating condition data and the mathematical model to obtain the identification result includes:

discretizing the mathematical model based on the historical operating condition data to obtain a discretized mathematical model; and
performing parameter identification on the battery parameter of the battery module based on the historical operating condition data and the discretized mathematical model to obtain the identification result.

In practical applications, sampled data of an observable parameter of the battery module are typically discrete. In the embodiments of the present application, discretizing the mathematical model enables the mathematical model to more accurately reflect the actual state of the battery module, thereby facilitating improved estimation accuracy of the state of health of the battery.

In an implementation of the first aspect, the discretizing the mathematical model based on the historical operating condition data to obtain a discretized mathematical model includes:

obtaining a sampling frequency of the historical operating condition data; and
discretizing the mathematical model based on the sampling frequency of the historical operating condition data to obtain the discretized mathematical model.

In the embodiments of the present application, the mathematical model is discretized based on the sampling frequency of the battery module to align a time interval in the mathematical model with the actual sampling frequency. This approach enables the mathematical model to more accurately reflect the actual state of the battery module, thereby facilitating improved estimation accuracy of the state of health of the battery.

In an implementation of the first aspect, the performing parameter identification on the battery parameter of the battery module based on the historical operating condition data and the discretized mathematical model to obtain the identification result includes:

establishing an identification model based on the discretized mathematical model; and
performing parameter identification based on the historical operating condition data and the identification model to obtain the identification result.

In the embodiments of the present application, converting the mathematical model of the battery module into the identification model is equivalent to transforming a practical problem into a mathematical problem, facilitating subsequent calculations.

In an implementation of the first aspect, the establishing an identification model based on the discretized mathematical model includes:

constructing a target function based on the discretized mathematical model;
obtaining a constraint condition for an independent variable in the mathematical model; and
establishing the identification model based on the target function and the constraint condition.

In practical applications, the battery parameter of the battery module cannot take unrestricted values. In the embodiments of the present application, adding the constraint condition to the independent variable of the mathematical model is equivalent to limiting the value range of the battery parameter of the battery module, that is, performing battery parameter identification within a specific value range. This approach can rapidly identify an optimal solution, and the obtained optimal solution better aligns with actual conditions, thereby facilitating improved estimation accuracy of the battery state of health.

In an implementation of the first aspect, the independent variable includes an initial state of charge of the battery module; and

the obtaining a constraint condition for an independent variable in the mathematical model includes:

obtaining historical data of the initial state of charge from the historical operating condition data, and
determining a constraint condition for the initial state of charge based on first frame data in the historical data of the initial state of charge.

In an implementation of the first aspect, the independent variable includes a battery capacity of the battery module; and

the obtaining a constraint condition for an independent variable in the mathematical model includes:

obtaining historical charging data of the battery module from the historical operating condition data,

estimating the battery capacity of the battery module based on the historical charging data to obtain an estimated value of the battery capacity, and

determining a constraint condition for the battery capacity based on the estimated value of the battery capacity.

In the above embodiments, setting the constraint condition for the independent variable based on the historical data of the independent variable. Because the historical data are actual operating condition data, the constraint condition set based on the historical data can more accurately reflect the actual state of the battery module, thereby improving the reliability of the identification result.

In an implementation of the first aspect, the constraint condition includes a linear constraint and a nonlinear constraint; and

the establishing the identification model based on the target function and the constraint condition includes:

adding a multiplier to the nonlinear constraint of the constraint condition to obtain a nonlinear constraint term,

adding the nonlinear constraint term to the target function to obtain an updated target function, and

establishing the identification model based on the updated target function and the linear constraint of the constraint condition.

In the embodiments of the present application, adding the multiplier to the nonlinear constraint and adding the nonlinear constraint term to the target function is equivalent to converting a problem with nonlinear constraints into a problem without nonlinear constraints, reducing the algorithmic complexity of parameter identification.

In an implementation of the first aspect, the independent variable of the mathematical model includes an observable quantity and a non-observable quantity, and the historical operating condition data include an initial value of the non-observable quantity, historical observation data of the observable quantity, and historical observation data of a dependent variable of the mathematical model; and

the performing parameter identification based on the historical operating condition data and the identification model to obtain the identification result includes:

inputting the initial value of the non-observable quantity, the historical observation data of the observable quantity, and the historical observation data of the dependent variable into the identification model to obtain a first value of the target function,

adjusting the value of the non-observable quantity based on the first value to obtain a first adjusted value of the non-observable quantity,

inputting the first adjusted value, the historical observation data of the observable quantity, and the historical observation data of the dependent variable into the identification model to obtain a second value of the target function, and

if the second value does not satisfy a preset condition, continuing to adjust the value of the non-observable quantity based on the second value until the value of the target function satisfies the preset condition, and

if the second value satisfies the preset condition, determining a current value of the non-observable quantity as the identification result.

In the embodiments of the present application, during the parameter identification process, iterative calculations are performed using actual operating condition data of the battery module, rather than recursive solving, resulting in more stable and reliable identification results.

In an implementation of the first aspect, the adjusting the value of the non-observable quantity based on the first value to obtain a first adjusted value of the non-observable quantity includes:

determining a feasible range of the non-observable quantity based on the first value; and

determining the first adjusted value from the feasible range, where a value of the target function corresponding to the first adjusted value is less than a value of the target function corresponding to any other adjusted value within the feasible range.

In the embodiments of the present application, continuously adjusting the feasible range of the non-observable quantity based on the value of the target function and seeking a point with a minimum value of the target function within the feasible range are equivalent to converting a point search problem into a local range search problem. This approach can allow for rapid convergence to obtain an optimal solution, effectively improving the efficiency of parameter identification and thus the efficiency of battery state of health estimation.

In an implementation of the first aspect, the method further includes:

optimizing the mathematical model of the battery module according to a preset cycle.

Periodically optimizing the mathematical model of the battery module allows the mathematical model to change with usage of the battery module, aligning more closely with the actual operating conditions of the battery module. This effectively avoids a poor identification result caused by inaccuracy in the mathematical model, thereby facilitating improved reliability of the identification result.

In an implementation of the first aspect, a step of updating the mathematical model of the battery module each time includes:

> determining a dependent variable of the mathematical model based on the battery parameter;
> determining an independent variable related to the dependent variable based on the battery parameter; and
> constructing the mathematical model based on the independent variable and the dependent variable.

In the embodiments of the present application, both the dependent variable and independent variable of the mathematical model of the battery module are determined based on the battery parameter of the battery module, enabling the constructed mathematical model to more accurately reflect the state of the battery module and providing a reliable model foundation for subsequent parameter identification.

In an implementation of the first aspect, the constructing the mathematical model based on the independent variable and the dependent variable includes:

> obtaining an equivalent circuit model of the battery module; and
> constructing the mathematical model between the independent variable and the dependent variable based on the equivalent circuit model.

In the embodiments of the present application, the mathematical model of the battery module is constructed based on the equivalent circuit model of the battery module. In the equivalent circuit model, some complex structures are typically replaced with simpler structures, and in a replaced circuit, unreplaced parts maintain the same effects as those in the original circuit. Therefore, the foregoing approach can simplify the model while ensuring that the mathematical model can accurately reflect the state of the battery module, thereby simplifying subsequent calculations.

In an implementation of the first aspect, the equivalent circuit model includes a first resistor, a second resistor, a first capacitor, and a battery, where the second resistor and the first capacitor are connected in parallel to form a parallel circuit, and the battery, the first internal resistance, and the parallel circuit are connected in series; and
when the dependent variable is an output voltage of the battery module, the constructing the mathematical model between the independent variable and the dependent variable based on the equivalent circuit model includes:

> constructing a first expression for an open-circuit voltage of the battery based on the independent variable, where the open-circuit voltage represents a potential difference between a positive electrode and a negative electrode of the battery;
> constructing a second expression for an internal resistance voltage of the first internal resistance based on the independent variable, where the internal resistance voltage representing a potential difference between two connection terminals of the first internal resistance;
> constructing a third expression for a parallel voltage of the parallel circuit based on the independent variable, where the parallel voltage represents a potential difference between two connection terminals of the parallel circuit; and
> constructing the mathematical model based on the first expression, the second expression, and the third expression.

In the embodiments of the present application, the equivalent circuit model employs a simple series and parallel connection of the resistors, the capacitor, and the battery, with only one dynamic element (the capacitor) in the equivalent circuit model. That is, the equivalent circuit model is equivalent to a first-order circuit, with a corresponding state equation being a first-order linear ordinary differential equation. This equivalent circuit model has a simple structure and linear state equation. Therefore, the mathematical model constructed based on the equivalent circuit model is simple and facilitates subsequent calculations.

Additionally, in the embodiments of the present application, the first expression, second expression, and third expression are all voltage expressions, equivalent to establishing the mathematical model based on relationships between voltages of different branches in the battery module. The mathematical model established in this approach can reflect the state of the output voltage of the battery module. Because the output voltage of the battery module is observable, the foregoing approach provides a model foundation for subsequent parameter identification.

In an implementation of the first aspect, the independent variable includes an output current, a battery capacity, and an initial state of charge of the battery module; and
the constructing a first expression for an open-circuit voltage of the battery based on the independent variable includes:

constructing a fourth expression for a real-time state of charge based on the output current, the battery capacity, and the initial state of charge of the independent variable, and

constructing the first expression based on the fourth expression and a relationship between the real-time state of charge and the open-circuit voltage.

The independent variables such as the battery capacity and initial state of charge are closely related to the state of health of the battery. In the embodiments of the present application, constructing expressions between the independent variables and branch voltages of the battery module enables parameter identification of the independent variables related to the state of health of the battery during the subsequent parameter identification process, facilitating the calculation of the state of health of the battery based on the identified parameter (the independent variable). This approach eliminates the need to convert the identified parameter into a parameter related to the state of health of the battery after the identification result is obtained, and instead directly uses the identified parameter to calculate the state of health of the battery, thereby simplifying the steps of the estimation method.

In an implementation of the first aspect, the independent variable includes the first resistor, and the constructing a second expression for an internal resistance voltage of the first internal resistance based on the independent variable includes:

constructing the second expression based on the output current, the first resistor, and the fourth expression of the independent variable.

The independent variables such as the first resistor, battery capacity, and initial state of charge are non-observable parameters of the battery module, and independent variables such as the battery capacity and initial state of charge are closely related to the state of health of the battery. In the embodiments of the present application, constructing expressions between the independent variables and branch voltages of the battery module is equivalent to establishing relationships between the non-observable parameters of the battery module and an observable parameter (output voltage) of the battery module. During the subsequent identification process, data of the non-observable parameters and a parameter related to the state of health of the battery can be identified using data of the observable parameter. This approach provides a model basis for subsequent parameter identification, helping to accurately obtain the state of the battery module, thereby improving the estimation accuracy of the state of health of the battery.

In an implementation of the first aspect, the independent variable includes an output current, the first capacitor, and the second resistor of the battery module; and

the constructing a third expression for a parallel voltage of the parallel circuit based on the independent variable includes: constructing the third expression based on the output current, the first capacitor, and the second resistor among the independent variable.

The first capacitor and the first resistor are non-observable parameters of the battery module. In the embodiments of the present application, constructing expressions between the independent variables and branch voltages of the battery module is equivalent to establishing relationships between the non-observable parameters of the battery module and an observable parameter (output voltage) of the battery module. During the subsequent identification process, data of the non-observable parameters can be identified using data of the observable parameter. This approach provides a model basis for subsequent parameter identification, helping to accurately obtain the state of the battery module, thereby improving the estimation accuracy of the state of health of the battery.

In an implementation of the first aspect, the identification result includes a battery capacity of the battery module; and

the predicting a state of health of a battery in the battery module based on the identification result includes: predicting the state of health of the battery in the battery module based on a value of the battery capacity in the identification result.

In the embodiments of the present application, since the identified battery parameter of the battery module is more accurate, the state of health of the battery estimated based on the identification result is also more accurate.

According to a second aspect, an electronic device is provided, including a memory, a processor, and a computer program stored in the memory and capable of running on the processor, where when the computer program is executed by the processor, the battery state of health estimation method according to any embodiment of the first aspect is implemented.

According to a third aspect, a computer-readable storage medium is provided, where the computer-readable storage medium stores a computer program, and when the computer program is executed by a processor, the battery state of health estimation method according to any embodiment of the first aspect is implemented.

According to a fourth aspect, an embodiment of the present application provides a computer program product, where when the computer program product is executed on a terminal device, the terminal device performs the battery state of health estimation method according to any embodiment of the first aspect.

It can be understood that the beneficial effects of the second aspect to the fourth aspect can be referred to the relevant descriptions in the first aspect, and are not repeated herein again.

The above description is merely an overview of the technical solutions of the present application. To facilitate a clearer understanding of the technical means of the present application, the content of the specification may be implemented, and to make the above and other objectives, features, and advantages of the present application more apparent and understandable, specific embodiments of the present application are provided below.

**BRIEF DESCRIPTION OF DRAWINGS**

Through the detailed description of preferred embodiments below, various other advantages and benefits will become apparent to those skilled in the art. The drawings are provided solely for illustrating preferred embodiments and are not considered to limit the present application. Throughout the drawings, identical components are denoted by identical reference numerals. In the accompanying drawings:

FIG. 1 is a schematic flowchart of a battery state of health estimation method provided by an embodiment of the present application;
FIG. 2 is a schematic flowchart of a mathematical model construction method provided by an embodiment of the present application;
FIG. 3 is a schematic diagram of a second-order equivalent circuit provided by an embodiment of the present application;
FIG. 4 is a schematic diagram of an equivalent circuit provided by an embodiment of the present application;
FIG. 5 is a schematic flowchart of a parameter identification method provided by an embodiment of the present application; and
FIG. 6 is a schematic structural diagram of an electronic device provided by an embodiment of the present application.

**DESCRIPTION OF EMBODIMENTS**

The embodiments described below are merely exemplary to illustrate the technical solutions of the present application more clearly and are not intended to limit the scope of protection of the present application.
Unless otherwise defined, all technical and scientific terms used herein have the same meanings as commonly understood by those skilled in the technical field of the present application. The terms used herein are solely for describing the embodiments and are not intended to limit the present application. The terms "including" and "having" in the specification, claims, and descriptions of the drawings, as well as any variations thereof, are intended to cover non-exclusive inclusion.
In the description of the embodiments of the present application, technical terms such as "first" and "second" are used solely to distinguish different objects and should not be construed as indicating or implying relative importance, or implicitly indicating the number, specific order, or primary-secondary relationship of the indicated technical features. In the description of the embodiments of the present application, "plurality" means two or more, unless explicitly and specifically limited otherwise.
Reference to "embodiment" herein means that specific features, structures, or characteristics described in connection with the embodiment may be included in at least one embodiment of the present application. The appearance of this phrase in various locations in the specification does not necessarily refer to the same embodiment, nor is it an independent or alternative embodiment mutually exclusive with other embodiments. Those skilled in the art explicitly and implicitly understand that the embodiments described herein may be combined with other embodiments.
In the description of the embodiments of the present application, the term "and/or" denotes an associative relationship describing associated objects, indicating that three relationships may exist. For example, A and/or B may indicate: A exists alone, A and B exist simultaneously, or B exists alone. Additionally, the character "/" herein generally indicates an "or" relationship between the associated objects.
With the development of electric vehicles, the service life of batteries has gained increasing attention. Battery state of health (state of health, SOH), also referred to as a battery degradation coefficient, is used to reflect an aging degree and health degree of batteries. A higher SOH value indicates a lower aging degree and a higher health degree of batteries. A lower SOH value indicates a higher aging degree and lower health degree of batteries. However, related SOH value estimation methods typically exhibit low estimation accuracy, thereby affecting users' understanding of battery conditions.
To address the above issue, the embodiments of the present application provide a battery state of health estimation method. In the embodiments of the present application, a to-be-tested battery module is converted into a mathematical model, parameter identification is performed in combination with the mathematical model to identify the parameter of the battery module, and a state of health of a battery is predicted based on the identified parameter of the battery module. This method can effectively improve the estimation accuracy of the battery state of health.
The battery state of health estimation method provided by the embodiments of the present application is described below with reference to the embodiments.

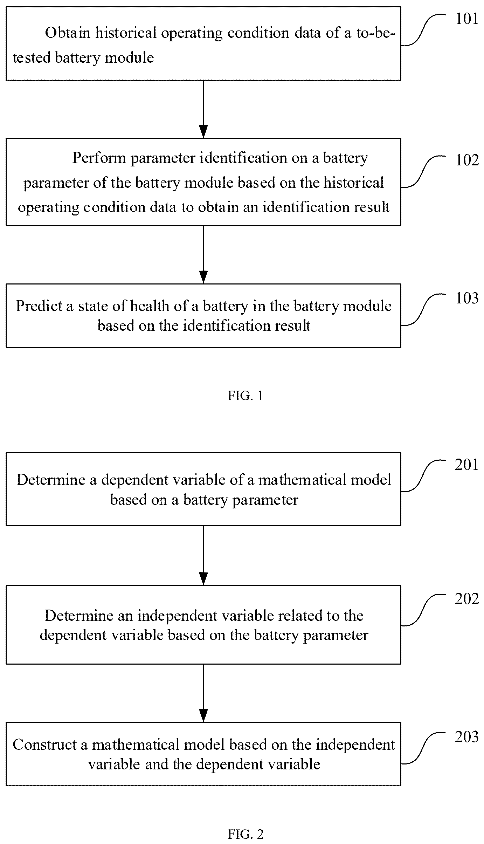

FIG. 1 is a schematic flowchart of a battery state of health estimation method provided by an embodiment of the present application. As an example and not a limitation, as shown in FIG. 1, the battery state of health estimation method includes the following steps: S101: Obtain historical operating condition data of a to-be-tested battery module.

In the embodiments of the present application, the historical operating condition data refer to actual data corresponding to a battery parameter of the battery module during historical operation of the battery module.

S102: Perform parameter identification on the battery parameter of the battery module based on the historical operating condition data to obtain an identification result.

In the embodiments of the present application, the battery module includes a battery (or referred to as a cell) and a circuit component configured to regulate an output current or output voltage of the battery module. Accordingly, the battery parameter of the battery module may include the output current and the output voltage of the battery module, a battery open-circuit voltage, a parameter of the circuit component in the battery module, and the like.

Parameter identification technology is a technique that combines theoretical models with experimental data for prediction. Parameter identification determines a set of model parameters based on the experimental data and an established model, enabling numerical results calculated by the model to best fit the test data (considered as a curve-fitting problem), thereby allowing prediction of unknown processes and providing theoretical guidance. In specific studies, a rough model is first established, and predictions are made for experimental measurement results using this rough model. When calculated numerical results exhibit significant errors as compared with test values, the mathematical model is considered inconsistent with or significantly different from an actual process, the model is revised and reselection and modification are made. When the predicted results align with the measured results, the model is deemed reliable.

In the embodiments of the present application, the battery parameter of the battery module includes an observable quantity (whose parameter value can be obtained through observation) and a non-observable quantity (whose parameter value cannot be obtained through observation). Parameter identification can fit data of the non-observable quantity in the battery module, thereby obtaining the operating state of the battery module and predicting the state of health of the battery of the battery module.

S103: Predict a state of health of a battery in the battery module based on the identification result.

In the embodiment of FIG. 1, performing parameter identification on the battery parameter based on the historical operating condition data of the battery module is equivalent to an offline identification approach. Compared with a real-time identification approach, the offline identification approach can avoid instability in identification results caused by recursive solving. Additionally, since parameter identification is conducted based on the historical operating condition data of the battery module, the battery parameter of the battery module can be accurately fitted, thereby effectively improving the estimation accuracy of the battery state of health.

In some embodiments, S102 includes:

obtaining a mathematical model of the battery module, where the mathematical model is constructed based on the battery parameter of the battery module; and
performing parameter identification on the battery parameter of the battery module based on the historical operating condition data and the mathematical model to obtain the identification result.

In the embodiments of the present application, the constructed mathematical model can reflect a circuit operating state of the battery module. A construction process of the mathematical model is detailed in description of the mathematical model optimization embodiment below, which is not provided herein.

In the embodiments of the present application, parameter identification is performed in combination with the mathematical model to identify the parameter of the battery module, and then the state of health of the battery is predicted based on the identified parameter of the battery module. Since the mathematical model is constructed based on the battery parameter of the battery module, the mathematical model can accurately reflect the state of the battery module, providing a reliable model foundation for subsequent parameter identification. Additionally, the parameter identification method can provide accurate fitting of the battery parameter of the battery module. Combining the mathematical model and the parameter identification method can effectively improve the estimation accuracy of the battery state of health.

In some embodiments, the method further includes:

optimizing the mathematical model of the battery module according to a preset cycle.

Periodically optimizing the mathematical model of the battery module allows the mathematical model to change with usage of the battery module, aligning more closely with the actual operating conditions of the battery module. This effectively avoids a poor identification result caused by inaccuracy in the mathematical model, thereby facilitating improved reliability of the identification result.

In some embodiments, FIG. 2 is a schematic flowchart of a mathematical model construction method provided by an embodiment of the present application. As an example and not a limitation, as shown in FIG. 2, a step of optimizing the mathematical model of the battery module each time includes:

S201: Determine a dependent variable of the mathematical model based on the battery parameter.

S202: Determine an independent variable related to the dependent variable based on the battery parameter.

S203: Construct the mathematical model based on the independent variable and the dependent variable.

In some examples, the dependent variable may be an output voltage of the battery module, and the independent variable may include an output current of the battery module, and a resistor, a capacitor, a battery capacity of a battery, a state of charge, and the like of the battery module.

In other examples, the dependent variable may be an output current of the battery module, and the independent variable may include an output voltage the battery module, and a resistor, a capacitor, a battery capacity of a battery, a state of charge, and the like of the battery module.

In practical applications, calculations involving the output voltage are simpler as compared with the output current. Therefore, the dependent variable being the output voltage may be used.

In the embodiments of the present application, both the dependent variable and independent variable of the mathematical model of the battery module are determined based on the battery parameter of the battery module, enabling the constructed mathematical model to more accurately reflect the state of the battery module and providing a reliable model foundation for subsequent parameter identification.

In some embodiments, an implementation of S201 may include:

obtaining an equivalent circuit model of the battery module; and constructing the mathematical model between the independent variable and the dependent variable based on the equivalent circuit model.

The equivalent circuit refers to a circuit whose complex structures are replaced with simpler structures, and in a replaced circuit, unreplaced parts maintain the same effects as those in the original circuit (or referred to as an external circuit).

In the embodiment of FIG. 2, the mathematical model of the battery module is constructed based on the equivalent circuit model of the battery module. In the equivalent circuit model, some complex structures are typically replaced with simpler structures, and in a replaced circuit, unreplaced parts maintain the same effects as those in the original circuit. Therefore, the foregoing approach can simplify the model while ensuring that the mathematical model can accurately reflect the state of the battery module, thereby simplifying subsequent calculations.

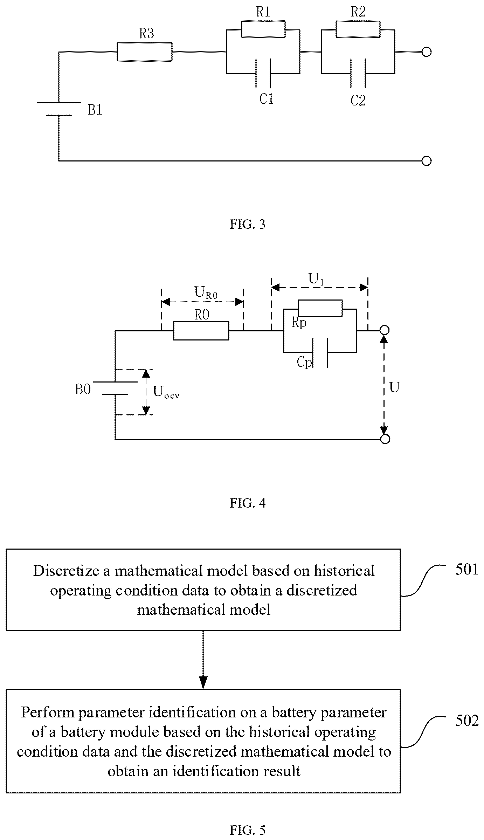

In some implementations, the equivalent circuit model may adopt a second-order RC equivalent circuit. FIG. 3 is a schematic diagram of a second-order equivalent circuit provided by an embodiment of the present application. A second-order equivalent circuit typically includes two dynamic elements. The second-order RC equivalent circuit shown in FIG. 3 includes three resistors R1, R2, and R3, two capacitors C1 and C2, and a battery B1. The capacitors C1 and C2 are dynamic elements. Accordingly, a corresponding state equation is a second-order nonlinear equation, which is computationally complex. To simplify calculations, the following approach may be adopted in the embodiments of the present application.

In an implementation, the equivalent circuit model includes a first resistor, a second resistor, a first capacitor, and a battery. The second resistor and the first capacitor are connected in parallel to form a parallel circuit, and the battery, the first internal resistance, and the parallel circuit are connected in series.

FIG. 4 is a schematic diagram of an equivalent circuit provided by an embodiment of the present application. As an example and not a limitation, as shown in FIG. 4, the equivalent circuit includes a first resistor R0, a second resistor Rp, a first capacitor Cp, and a battery B0. The first resistor R0 is equivalent to an ohmic internal resistance of the battery module, which is composed of internal resistances of electrode materials, an electrolyte, and a separator, and contact resistances of various components. The second resistor Rp is equivalent to a polarization internal resistance of the battery module, which is an internal resistance caused by polarization during electrochemical reactions, typically including electrochemical polarization and concentration polarization resistances. The first capacitor Cp is equivalent to a polarization capacitance of the battery module, which is a capacitance with positive and negative electrodes. The polarization capacitance and polarization internal resistance are connected in parallel to form a capacitive-resistive circuit, used to simulate dynamic characteristics exhibited during generation and elimination processes of battery polarization.

In the embodiments of the present application, the equivalent circuit model employs a simple series and parallel connection of the resistors, the capacitor, and the battery, with only one dynamic element (the capacitor) in the equivalent circuit model. That is, the equivalent circuit model is equivalent to a first-order circuit, with a corresponding state equation being a first-order linear ordinary differential equation. This equivalent circuit model has a simple structure and linear state equation. Therefore, the mathematical model constructed based on the equivalent circuit model is simple and facilitates subsequent calculations.

For ease of description, the dependent variable being the output voltage of the battery module is used as an example to describe the construction process of the mathematical model in the following embodiments.

The constructing the mathematical model between the independent variable and the dependent variable based on the equivalent circuit model includes:

1. Constructing a first expression for an open-circuit voltage of the battery based on the independent variable, where the open-circuit voltage represents a potential difference between a positive electrode and a negative electrode of the battery.

The open-circuit voltage of the battery is denoted as $U_{ocv}$ as shown in FIG. 4.

Optionally, the independent variable includes an output current, a battery capacity, and an initial state of charge of the battery module. A construction manner of the first expression in step 1 includes:

constructing a fourth expression for a real-time state of charge based on the output current, the battery capacity, and the initial state of charge of the independent variable, and

constructing the first expression based on the fourth expression and a relationship between the real-time state of charge and the open-circuit voltage.

For example, the fourth expression is $SOC(t) = SOC(0) + \frac{\int_0^t I(x)dx}{3600Q_0}$, where $SOC(t)$ represents a real-time state of charge at time t, $SOC(0)$ represents the initial state of charge, $I(x)$ represents an output current at time x, and $Q_0$ represents the battery capacity. It should be noted that a charging current of a battery is typically defined as positive, and a discharging current is defined as negative. In the expression illustrated in the embodiments of the present application, the output current $I(x)$ is a charging current. If a discharging current is used, the sign of the output current in the expression is modified accordingly.

The first expression is $U_{OCV}(t) = U_{OCV}\big(SOC(t)\big) = U_{OCV}\left(SOC(0) + \frac{\int_0^t I(x)dx}{3600Q_0}\right)$, where $U_{OCV}(t)$ represents an open-circuit voltage at time t.

The independent variables such as the battery capacity and initial state of charge are closely related to the state of health of the battery. In the embodiments of the present application, constructing expressions between the independent variables and branch voltages of the battery module enables parameter identification of the independent variables related to the state of health of the battery during the subsequent parameter identification process, facilitating the calculation of the state of health of the battery based on the identified parameter (the independent variables). This approach eliminates the need to convert the identified parameter into a parameter related to the state of health of the battery after the identification result is obtained, and instead directly uses the identified parameter to calculate the state of health of the battery, thereby simplifying the steps of the estimation method.

2. Constructing a second expression for an internal resistance voltage of the first internal resistance based on the independent variable, where the internal resistance voltage represents a potential difference between two connection terminals of the first internal resistance.

The internal resistance voltage of the first internal resistance is denoted as $U_{R0}$ as shown in FIG. 4.

Optionally, the independent variable includes the first resistor. A construction manner of the second expression in step 2 includes:

constructing the second expression based on the output current, the first resistor, and the fourth expression of the independent variable.

For example, the second expression is $U_{R0}(t) = I(t)R_0\big(SOC(t)\big) = I(t)R_0\left(SOC(0) + \frac{\int_0^t I(x)dx}{3600Q_0}\right)$, where $U_{R0}(t)$ represents an internal resistance voltage of the first internal resistance at time t.

The independent variables such as the first resistor, battery capacity, and initial state of charge are non-observable parameters of the battery module, and independent variables such as the battery capacity and initial state of charge are closely related to the state of health of the battery. In the embodiments of the present application, constructing expressions between the independent variables and branch voltages of the battery module is equivalent to establishing relationships between the non-observable parameters of the battery module and an observable parameter (output voltage) of the battery module. During the subsequent identification process, data of the non-observable parameters and a parameter related to the state of health of the battery can be identified using data of the observable parameter. This approach provides a model basis for subsequent parameter identification, helping to accurately obtain the state of the battery module, thereby improving the estimation accuracy of the state of health of the battery.

3. Constructing a third expression for a parallel voltage of the parallel circuit based on the independent variable, where the parallel voltage represents a potential difference between two connection terminals of the parallel circuit.

The parallel voltage of the parallel circuit is denoted as $U_1$ as shown in FIG. 4.

Optionally, the independent variable includes an output current, the first capacitor, and the second resistor of the battery module. A construction manner of the third expression in step 3 includes:

constructing the third expression based on the output current, the first capacitor, and the second resistor among the independent variable.

For example, the third expression is $U_1(t) = \left(I(t) - C_p\frac{dU_1}{dt}\right)R_p$, where $U_1(t)$ represents a parallel voltage at

time t, $C_p$ represents the first capacitor, and $R_p$ represents the second resistor.

The first capacitor and the first resistor are non-observable parameters of the battery module. In the embodiments of the present application, constructing expressions between the independent variables and branch voltages of the battery module is equivalent to establishing relationships between the non-observable parameters of the battery module and an observable parameter (output voltage) of the battery module. During the subsequent identification process, data of the non-observable parameters can be identified using data of the observable parameter. This approach provides a model basis for subsequent parameter identification, helping to accurately obtain the state of the battery module, thereby improving the estimation accuracy of the state of health of the battery.

4. Constructing the mathematical model based on the first expression, the second expression, and the third expression.

According to the Kirchhoffs voltage law, the output voltage of the battery module is a sum of voltages of all branches, that is, a sum of the open-circuit voltage of the battery, the internal resistance voltage of the first internal resistance, and the parallel voltage of the parallel circuit. For example, the obtained mathematical model may be:

$$U(t) = U_{OCV}(t) + U_{R0}(t) + U_1(t) = I(t)R_0\big(SOC(t)\big) + U_{OCV}\left(SOC(0) + \frac{\int_0^t I(x)dx}{3600Q_0}\right) + \Big(I(t) -$$

$$C_p\frac{dU_1}{dt}\Big)R_p;$$

where $U(t)$ represents an output voltage of the battery module at time t.

In the embodiments of the present application, the first expression, second expression, and third expression are all voltage expressions, equivalent to establishing the mathematical model based on relationships between voltages of different branches in the battery module. The mathematical model established in this approach can reflect the state of the output voltage of the battery module. Because the output voltage of the battery module is observable, the foregoing approach provides a model foundation for subsequent parameter identification.

It can be understood that if the dependent variable is the output current of the battery module, the principle of constructing the mathematical model is similar to the above embodiment, and reference can be made to the description in the above embodiment. Details are not repeated herein again.

In the above embodiment, the state equation (mathematical model) of the output voltage of the battery module is constructed based on the Kirchhoff's voltage law. In practical applications, the mathematical model can alternatively be constructed based on the Kirchhoffs current law. It can be understood that other expressions may be used in practical applications. For example, in some simplified models, the internal resistance voltage of the first resistor is ignored. For another example, in some models, the open-circuit voltage of the battery does not consider the battery capacity of the battery. In other words, different selections of independent variables and/or different selections of equivalent circuit models result in different mathematical models. The above mathematical model is merely an example, and the embodiments of the present application do not specifically limit the form of the mathematical model.

The mathematical model obtained in the above embodiment is continuous, while in practical applications, sampled data of the observable parameter of the battery module are typically discrete. Using a continuous mathematical model to identify the discrete state of the battery module may affect the accuracy of the identification result.

To address this issue, in some embodiments, FIG. 5 is a schematic flowchart of a parameter identification method provided by an embodiment of the present application. As an example and not a limitation, as shown in FIG. 5, an implementation of step S102 may include:

S501: Discretize the mathematical model based on the historical operating condition data to obtain a discretized mathematical model.

In an implementation, a sampling interval may be artificially preset, and the mathematical model is discretized based on this preset sampling interval. However, the preset sampling interval in this manner may differ from an actual sampling interval of the battery module, resulting in a discretized mathematical model that fails to reflect the true operating state of the battery module.

To address this issue, in an implementation, S501 may include:

obtaining a sampling frequency of the historical operating condition data; and
discretizing the mathematical model based on the sampling frequency of the historical operating condition data to obtain the discretized mathematical model.

For example, the mathematical model in the above embodiment is used as an example. The discretized mathematical model is:

$$U^k = U_{OCV}^k + U_{R0}^k + U_1^k$$

$$= I^k R_0 + U_{OCV}^k \left( SOC^0 + \frac{I^k \Delta t}{3600 Q_0} \right) + U_1^{k-1} (e^{-\Delta t})^{\frac{1}{R_1 C_1}} + R_1 \left[ 1 - (e^{-\Delta t})^{\frac{1}{R_1 C_1}} \right] I^k;$$

where $\Delta t$ represents the sampling interval determined by the sampling frequency, $U^k$ represents an output voltage sampled at the k-th sampling moment, $I^k$ represents an output current sampled at the k-th sampling moment, and $SOC^0$ represents the initial state of charge.

In the embodiments of the present application, the mathematical model is discretized based on the sampling frequency of the battery module to align a time interval in the mathematical model with the actual sampling frequency. This approach enables the mathematical model to more accurately reflect the actual state of the battery module, thereby facilitating improved estimation accuracy of the state of health of the battery.

S502: Perform parameter identification on the battery parameter of the battery module based on the historical operating condition data and the discretized mathematical model to obtain the identification result.

In practical applications, sampled data of the observable parameter of the battery module are typically discrete. In the embodiment of FIG. 5, discretizing the mathematical model enabled the mathematical model to more accurately reflect the actual state of the battery module, thereby facilitating improved estimation accuracy of the state of health of the battery.

Specifically, S502 includes:

I. establishing an identification model based on the discretized mathematical model; and
II. performing parameter identification based on the historical operating condition data and the identification model to obtain the identification result.

In the embodiments of the present application, converting the mathematical model of the battery module into the identification model is equivalent to transforming a practical problem into a mathematical problem, facilitating subsequent calculations.

In an implementation of step I, a least squares model may be established based on the discretized mathematical model to evaluate an error between the calculated output voltage and the actual observed output voltage. For example, the identification model is:

$$min_x \frac{1}{K} \sum_{k=1}^{K} \left( \overline{U}^k - U^k \right)^2;$$

where $K$ represents the total number of sampling moments, $\overline{U}^k$ represents the actual value of the output voltage of the battery module collected at the k-th sampling moment, and x represents the parameter to be identified, for example, $x = [R_0, R_1, C_1, SOC^0, Q_0]$.

It can be seen from the example of the mathematical model above that the expression for the output voltage of the battery module is highly nonlinear and non-convex, which leads to multiple stationary points in the identification result. Additionally, in practical applications, the battery parameter of the battery module cannot take unrestricted values. To ensure that the identification model better aligns with the actual operating state of the battery module and to quickly search for the optimal solution, in some embodiments, Step I may include:

I-1. constructing a target function based on the discretized mathematical model;
1-2. obtaining a constraint condition for an independent variable in the mathematical model; and
I-3. establishing the identification model based on the target function and the constraint condition.

In the embodiments of the present application, adding the constraint condition to the independent variable of the mathematical model is equivalent to limiting the value range of the battery parameter of the battery module, that is, performing battery parameter identification within a specific value range. This approach can rapidly identify an optimal solution, and the obtained optimal solution better aligns with actual conditions, thereby facilitating improved estimation accuracy of the battery state of health.

Optionally, the independent variable includes a first resistor, a second resistor, and a first capacitor. The constraint conditions for these independent variables may be limited to being greater than 0.

Optionally, the independent variable includes a real-time state of charge. The constraint condition for the real-time state of charge may be limited to falling within the interval [0, 1].

Optionally, the independent variable includes an open-circuit voltage of the battery. The constraint condition for the open-circuit voltage may be limited to being less than or equal to the output voltage of the battery module. Optionally, the independent variable includes an initial state of charge of the battery module. Accordingly, step I-2 includes:

obtaining historical data of the initial state of charge from the historical operating condition data; and
determining a constraint condition for the initial state of charge based on first frame data in the historical data of the initial state of charge.

In practical applications, a battery management system (Battery Management System, BMS) can report the state of charge of the battery. The historical data of the initial state of charge refer to states of charge of the battery reported by the BMS historically.

In an implementation, maximum and minimum values of the historical data of the initial state of charge may be determined as upper and lower limits of the constraint condition, respectively. However, there may be some error between the data reported by the BMS and the actual data, and the numerical range between the maximum and minimum values of the historical data may be large. These are not conducive to subsequent identification calculations. In another implementation, a numerical range may be determined based on the first frame data of the historical data of the initial state of charge. For example, a preset value is added to the first frame data of the historical data as the upper limit of the constraint condition, a preset value is subtracted from the first frame data of the historical data as the lower limit of the constraint condition, and a numerical range between the upper and lower limits is determined as the constraint condition.

The first frame data in the historical data refers to the earliest collected frame of data in the historical data. For example, if the historical data includes K frames of data (data obtained from K samplings), with the earliest collected data being the 1st frame of data and the latest collected data being the K-th frame of data, the first frame data in the historical data is the 1st frame of data of the K frames of data.

Optionally, the independent variable includes a battery capacity of the battery module. Accordingly, step I-2 includes:

obtaining historical charging data of the battery module from the historical operating condition data,
estimating the battery capacity of the battery module based on the historical charging data to obtain an estimated value of the battery capacity, and
determining a constraint condition for the battery capacity based on the estimated value of the battery capacity.

The historical charging data include the percentage and charge amount of each charging. The battery capacity of the battery module can be estimated based on the percentage and charge amount of any single charging. For example, if a charging event involves charging the battery by 40% with a corresponding charge amount of 40 mA, the corresponding battery capacity is 40/40% = 100 mA.

In an implementation, the estimated value of the battery capacity may be determined as the upper limit of the constraint condition for the battery capacity. However, in practical applications, the estimated battery capacity may have some error. In another implementation, the estimated value of the battery capacity may be adjusted upward or downward by a preset value, and the adjusted estimated value is used as the upper limit of the constraint condition.

The constraint condition for the independent variable listed in the above embodiments are merely examples and are not intended to specifically limit the selection of the independent variable or the constraint condition of the independent variable.

In the above embodiments, setting the constraint condition for the independent variable based on the historical data of the independent variable. Because the historical data are actual operating condition data, the constraint condition set based on the historical data can more accurately reflect the actual state of the battery module, thereby improving the reliability of the identification result.

It can be seen from the above embodiments that the constraint condition includes a linear constraint (for example, constraint conditions for the first resistor, second resistor, and first capacitor) and a nonlinear constraint (for example, constraint conditions for the initial state of charge, battery capacity, open-circuit voltage, and real-time state of charge). The nonlinear constraint has higher computational complexity.

To reduce the computational complexity of the parameter identification model, in some embodiments, accordingly, step I-3 includes:

adding a multiplier to the nonlinear constraint of the constraint condition to obtain a nonlinear constraint term;
adding the nonlinear constraint term to the target function to obtain an updated target function; and
establishing the identification model based on the updated target function and the linear constraint of the constraint condition.

In an implementation, a Lagrange multiplier may be used to add the nonlinear constraint to the target function. For example, the identification model with the nonlinear constraint for the real-time state of charge is:

$$min_x \frac{1}{K}\sum_{k=1}^{K}\left(\overline{U}^k - U^k\right)^2;$$

s.t.

$$0 \le SOC^0 + \frac{I^k \Delta t}{3600 Q_0} \le 1.$$

With the Lagrange multiplier used to add the nonlinear constraint to the target function, the updated model is:

$$min_{(x,\lambda_1 \ge 0,\lambda_2 \ge 0)} \frac{1}{K}\sum_{k=1}^{K}\left(\overline{U}^k - U^k\right)^2 - \lambda_1\left(SOC^0 + \frac{I^k \Delta t}{3600 Q_0}\right) - \lambda_2\left(1 - SOC^0 - \frac{I^k \Delta t}{3600 Q_0}\right);$$

where $\lambda_1$ and $\lambda_2$ are Lagrange multipliers.

The above identification model is merely an example and only shows a portion related to the nonlinear constraint. In this implementation, only the nonlinear constraint may be added to the target function, while the linear constraint remains as a constraint condition outside the target function.

In the embodiments of the present application, adding the multiplier to the nonlinear constraint and adding the nonlinear constraint term to the target function is equivalent to converting a problem with nonlinear constraints into a problem without nonlinear constraints, reducing the algorithmic complexity of parameter identification.

In other implementations, the linear constraint may alternatively be added to the target function, converting a constrained problem into an unconstrained problem. In the embodiments of the present application, the independent variable of the mathematical model includes an observable quantity and a non-observable quantity. The observable quantity refers to a parameter whose actual value can be detected by devices or apparatuses, while the non-observable quantity refers to a parameter whose actual value cannot be detected by devices or apparatuses. The historical operating condition data include an initial value of the non-observable quantity, historical observation data of the observable quantity, and historical observation data of the dependent variable of the mathematical model.

For example, the non-observable quantity may include the state of charge, first resistor, second resistor, first capacitor, and battery capacity. The observable quantity may include the output current of the battery module. The initial value of the state of charge is denoted as the initial state of charge.

As described in the above embodiments, for the initial state of charge, the first piece of data in the historical data reported by the BMS may be used. If there is a sufficiently long static condition before charging, a voltage value in a data frame before charging can be used as the open-circuit voltage $U_{ocv}$ of the battery, and the value of the initial state of charge can be obtained by looking up an SOC-OCV table (a table of correspondences between states of charge and open-circuit voltages). For the initial value of the battery capacity, the estimated value of the battery capacity may be used. For the first resistor, second resistor, and first capacitor, initial values may be set based on factory parameters or artificially.

In some embodiments, step II may include:

inputting the initial value of the non-observable quantity, the historical observation data of the observable quantity, and the historical observation data of the dependent variable into the identification model to obtain a first value of the target function;

adjusting the value of the non-observable quantity based on the first value to obtain a first adjusted value of the non-observable quantity;

inputting the first adjusted value, the historical observation data of the observable quantity, and the historical observation data of the dependent variable into the identification model to obtain a second value of the target function;

if the second value satisfies a preset condition, determining a current value of the non-observable quantity as the identification result; and

if the second value does not satisfy the preset condition, continuing to adjust the value of the non-observable quantity based on the second value until the value of the target function satisfies the preset condition.

The preset condition may be that the value of the target function is less than a preset value. Certainly, other iteration termination conditions may alternatively be set, such as determining the number of iterations and stopping iteration when the number of iterations reaches a preset number.

The target function being $min_x \frac{1}{K}\sum_{k=1}^{K}\left(\overline{U}^k - U^k\right)^2$ is used as an example. The value of the target function can indicate the error between the identification result of the output voltage of the battery module and the actual observed value.

For example, it is assumed that the historical observation data include sampling data corresponding to K sampling moments. In the first iteration, initial values of the first resistor, second resistor, first capacitor, and battery capacity, the first piece of sampling data from the historical observation data of the initial state of charge and output current, and the first piece of sampling data from the historical observation data of the output voltage are input into the identification model to obtain the first value of the target function. The values of the real-time state of charge, first resistor, second resistor, first capacitor, and battery capacity are adjusted based on the first value to obtain their respective first adjusted values. The first adjusted values, the second piece of sampling data from the historical data of the output current, and the second piece of sampling data from the historical observation data of the output voltage are input into the identification model to obtain the second value of the target function. If the second value satisfies the preset condition, a current value of the non-observable quantity is determined as the identification result. If the second value does not satisfy the preset condition, continued adjusted of the values of the real-time state of charge, first resistor, second resistor, first capacitor, and battery capacity are performed based on the second value to obtain their respective second adjusted values. The second adjusted values, the third piece of sampling data from the historical data of the output current, and the third piece of sampling data from the historical observation data of the output voltage are input into the identification model to obtain the third value of the target function, and so on.

In the embodiments of the present application, during the parameter identification process, iterative calculations are performed using actual operating condition data of the battery module, rather than recursive solving, resulting in more stable and reliable identification results.

Optionally, the adjusting the value of the non-observable quantity based on the first value to obtain a first adjusted value of the non-observable quantity includes:

determining a feasible range of the non-observable quantity based on the first value; and
determining the first adjusted value from the feasible range, where a value of the target function corresponding to the first adjusted value is less than a value of the target function corresponding to any other adjusted value within the feasible range.

The feasible range herein is equivalent to a neighborhood or trust region of a current value of the non-observable quantity. In the above approach, if the first value is large, the feasible range may be appropriately reduced. If the first value is small, the feasible range may be appropriately expanded.

An implementation for determining the first adjusted value from the feasible range is: inputting each sampling value within the feasible range into the target function to calculate a corresponding value of the target function; and determining a sampling value corresponding to a smallest calculated value of the target function as the first adjusted value. Certainly, in other implementations, the gradient descent method, the approximation method, or the like may alternatively be used to search for the first adjusted value that minimizes the value of the target function within the feasible range. This is not specifically limited in the embodiments of the present application.

In the embodiments of the present application, continuously adjusting the feasible range of the non-observable quantity based on the value of the target function and seeking a point with a minimum value of the target function within the feasible range are equivalent to converting a point search problem into a local range search problem. This approach can allow for rapid convergence to obtain an optimal solution, effectively improving the efficiency of parameter identification and thus the efficiency of battery state of health estimation.

In some embodiments, the identification result includes the battery capacity of the battery module. Accordingly, S103 may include:
predicting the state of health of the battery in the battery module based on a value of the battery capacity in the identification result.

For example, the state of health of the battery was calculated according to the formula $SOH = \dfrac{Q_0}{\text{nominal capacity}}$. The nominal capacity of a battery refers to a minimum amount of charge that a battery is specified or guaranteed to deliver under a certain discharge condition during design and manufacturing of the battery.

In the embodiments of the present application, since the identified battery parameter of the battery module is more accurate, the state of health of the battery estimated based on the identification result is also more accurate.

It should be understood that the numbering of the steps in the above embodiments does not imply the order of execution. The execution order of each process should be determined by its function and inherent logic and should not constitute any limitation on the implementation process of the embodiments of the present application.

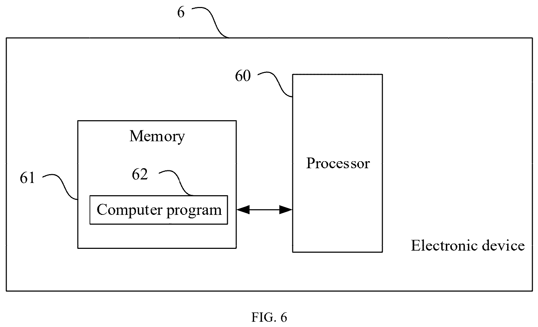

FIG. 6 is a schematic structural diagram of an electronic device provided by an embodiment of the present application. As shown in FIG. 6, the electronic device 6 of this embodiment includes: at least one processor 60 (only one is shown in FIG. 6), a memory 61, and a computer program 62 stored in the memory 61 and capable of running on the at least one processor 60. When the computer program 62 is executed by the processor 60, the steps in any one of the above embodiments of the battery state of health estimation method are implemented.

The electronic device may be a computing device such as a desktop computer, a laptop, a palmtop computer, or a cloud server. The electronic device may include, but is not limited to, a processor and a memory. Those skilled in the art can understand that FIG. 6 is merely an example of the electronic device 6 and does not constitute a limitation on the electronic device 6. It may include more or fewer components than shown, combine certain components, or include different components. For example, it may further include an input/output device, a network access device, or the like.

The processor 60 may be a central processing unit (Central Processing Unit, CPU). The processor 60 may alternatively be other general-purpose processors, a digital signal processor (Digital Signal Processor, DSP), an application-specific integrated circuits (Application Specific Integrated Circuit, ASIC), a field-programmable gate array (Field-Programmable Gate Array, FPGA) or other programmable logic devices, a discrete gate or transistor logic device, a discrete hardware component, or the like. The general-purpose processor may be a microprocessor, or the processor may be any conventional processor.

In some embodiments, the memory 61 may be an internal storage unit of the electronic device 6, such as a hard disk or memory of the electronic device 6. In some other embodiments, the memory 61 may alternatively be an external storage device of the electronic device 6, such as a plug-in hard disk, a smart media card (Smart Media Card, SMC), a secure digital (Secure Digital, SD) card, or a flash card (Flash Card) equipped on the electronic device 6. Further, the memory 61 may alternatively include both an internal storage unit and an external storage device of the electronic device 6. The memory 61 is configured to store an operating system, an application program, a boot loader (Boot Loader), data, and other programs, such as program code of the computer program. The memory 61 may alternatively be configured to temporarily store data that has been output or is to be output.

An embodiment of this application provides an electronic device including a memory, a processor, and a computer program stored in the memory and capable of running on the processor. When the computer program is executed by the processor, the battery state of health estimation method in the above embodiments is implemented.

An embodiment of this application provides a computer-readable storage medium, where the computer-readable storage medium stores a computer program, and when the computer program is executed by a processor, the battery state of health estimation method in the foregoing embodiments is implemented.

The embodiments further provide a computer program product. The computer-readable storage medium stores program code. When the computer program product is run on a computer, the computer is enabled to perform the foregoing related steps to implement the battery state of health estimation method in the foregoing embodiments.

If the integrated unit is implemented in the form of a software function unit and is sold or used as an independent product, the integrated unit may be stored in a computer-readable storage medium. Based on this understanding, all or part of the processes of the method in the embodiments of this application may be implemented by a computer program instructing related hardware. The computer program may be stored in the computer-readable storage medium, and when the computer program is executed by a processor, the steps in the foregoing method embodiments may be implemented. The computer program includes computer program code, where the computer program code may be source code, object code, an executable file, some intermediate forms, or the like. The computer-readable medium may include at least: any entity or device, recording medium, computer memory, read-only memory (ROM, Read-Only Memory), random access memory (RAM, Random Access Memory), electrical carrier signal, telecommunication signal, and software distribution media capable of carrying the computer program code to an apparatus/terminal device, such as a USB drive, a portable hard drive, a magnetic disk, or an optical disk. In some jurisdictions, according to legislation and patent practice, the computer-readable medium cannot be an electrical carrier signal or telecommunication signal.

In the above embodiments, the descriptions of each embodiment have their own emphases. For parts not detailed or recorded in a certain embodiment, reference may be made to the relevant descriptions of other embodiments.

Persons of ordinary skill in the art may be aware that the units and algorithmic steps in the examples described with reference to the embodiments disclosed herein can be implemented by electronic hardware or a combination of computer software and electronic hardware. Whether the functions are performed by hardware or software depends on particular applications and design constraints of the technical solutions. Persons skilled in the art may use different methods to implement the described functions for each particular application, but it should not be considered that the implementation goes beyond the scope of the present application.

**Claims**

1. A battery state of health estimation method **characterized by** comprising:

   obtaining historical operating condition data of a to-be-tested battery module;
   performing parameter identification on a battery parameter of the battery module based on the historical operating condition data to obtain an identification result; and
   predicting a state of health of a battery in the battery module based on the identification result.

2. The method according to claim 1, **characterized in that** the performing parameter identification on a battery parameter of the battery module based on the historical operating condition data to obtain an identification result comprises:

obtaining a mathematical model of the battery module, wherein the mathematical model is constructed based on the battery parameter of the battery module; and
performing parameter identification on the battery parameter of the battery module based on the historical operating condition data and the mathematical model to obtain the identification result.

3. The method according to claim 2, **characterized in that** the performing parameter identification on the battery parameter of the battery module based on the historical operating condition data and the mathematical model to obtain the identification result comprises:

discretizing the mathematical model based on the historical operating condition data to obtain a discretized mathematical model; and
performing parameter identification on the battery parameter of the battery module based on the historical operating condition data and the discretized mathematical model to obtain the identification result.

4. The method according to claim 3, **characterized in that** the discretizing the mathematical model based on the historical operating condition data to obtain a discretized mathematical model comprises:

obtaining a sampling frequency of the historical operating condition data; and
discretizing the mathematical model based on the sampling frequency of the historical operating condition data to obtain the discretized mathematical model.

5. The method according to claim 4, **characterized in that** the performing parameter identification on the battery parameter of the battery module based on the historical operating condition data and the discretized mathematical model to obtain the identification result comprises:

establishing an identification model based on the discretized mathematical model; and
performing parameter identification based on the historical operating condition data and the identification model to obtain the identification result.

6. The method according to claim 5, **characterized in that** the establishing an identification model based on the discretized mathematical model comprises:

constructing a target function based on the discretized mathematical model;
obtaining a constraint condition for an independent variable in the mathematical model; and
establishing the identification model based on the target function and the constraint condition.

7. The method according to claim 6, **characterized in that** the independent variable comprises an initial state of charge of the battery module; and
the obtaining a constraint condition for an independent variable in the mathematical model comprises:

obtaining historical data of the initial state of charge from the historical operating condition data, and
determining a constraint condition for the initial state of charge based on first frame data in the historical data of the initial state of charge.

8. The method according to claim 6, **characterized in that** the independent variable comprises a battery capacity of the battery module; and
the obtaining a constraint condition for an independent variable in the mathematical model comprises:

obtaining historical charging data of the battery module from the historical operating condition data,
estimating the battery capacity of the battery module based on the historical charging data to obtain an estimated value of the battery capacity, and
determining a constraint condition for the battery capacity based on the estimated value of the battery capacity.

9. The method according to any one of claims 6 to 8, **characterized in that** the constraint condition comprises a linear constraint and a nonlinear constraint; and
the establishing the identification model based on the target function and the constraint condition comprises:

adding a multiplier to the nonlinear constraint of the constraint condition to obtain a nonlinear constraint term, adding the nonlinear constraint term to the target function to obtain an updated target function, and establishing the identification model based on the updated target function and the linear constraint of the constraint condition.

10. The method according to any one of claims 6 to 9, **characterized in that** the independent variable of the mathematical model comprises an observable quantity and a non-observable quantity, and the historical operating condition data comprise an initial value of the non-observable quantity, historical observation data of the observable quantity, and historical observation data of a dependent variable of the mathematical model; and
the performing parameter identification based on the historical operating condition data and the identification model to obtain the identification result comprises:

inputting the initial value of the non-observable quantity, the historical observation data of the observable quantity, and the historical observation data of the dependent variable into the identification model to obtain a first value of the target function,
adjusting the value of the non-observable quantity based on the first value to obtain a first adjusted value of the non-observable quantity,
inputting the first adjusted value, the historical observation data of the observable quantity, and the historical observation data of the dependent variable into the identification model to obtain a second value of the target function,
if the second value does not satisfy a preset condition, continuing to adjust the value of the non-observable quantity based on the second value until the value of the target function satisfies the preset condition, and
if the second value satisfies the preset condition, determining a current value of the non-observable quantity as the identification result.

11. The method according to claim 10, **characterized in that** the adjusting the value of the non-observable quantity based on the first value to obtain a first adjusted value of the non-observable quantity comprises:

determining a feasible range of the non-observable quantity based on the first value; and
determining the first adjusted value from the feasible range, wherein a value of the target function corresponding to the first adjusted value is less than a value of the target function corresponding to any other adjusted value within the feasible range.

12. The method according to any one of claims 2 to 11, **characterized in that** the method further comprises:
optimizing the mathematical model of the battery module according to a preset cycle.

13. The method according to claim 12, **characterized in that** a step of updating the mathematical model of the battery module each time comprises:

determining a dependent variable of the mathematical model based on the battery parameter;
determining an independent variable related to the dependent variable based on the battery parameter; and
constructing the mathematical model based on the independent variable and the dependent variable.

14. The method according to claim 13, **characterized in that** the constructing the mathematical model based on the independent variable and the dependent variable comprises:

obtaining an equivalent circuit model of the battery module; and
constructing the mathematical model between the independent variable and the dependent variable based on the equivalent circuit model.

15. The method according to claim 14, **characterized in that** the equivalent circuit model comprises a first resistor, a second resistor, a first capacitor, and a battery, wherein the second resistor and the first capacitor are connected in parallel to form a parallel circuit, and the battery, the first internal resistance, and the parallel circuit are connected in series; and
when the dependent variable is an output voltage of the battery module, the constructing the mathematical model between the independent variable and the dependent variable based on the equivalent circuit model comprises:

constructing a first expression for an open-circuit voltage of the battery based on the independent variable, wherein the open-circuit voltage represents a potential difference between a positive electrode and a negative electrode of the battery;

constructing a second expression for an internal resistance voltage of the first internal resistance based on the independent variable, wherein the internal resistance voltage represents a potential difference between two connection terminals of the first internal resistance;

constructing a third expression for a parallel voltage of the parallel circuit based on the independent variable, wherein the parallel voltage represents a potential difference between two connection terminals of the parallel circuit; and

constructing the mathematical model based on the first expression, the second expression, and the third expression.

16. The method according to claim 15, **characterized in that** the independent variable comprises an output current, a battery capacity, and an initial state of charge of the battery module; and

the constructing a first expression for an open-circuit voltage of the battery based on the independent variable comprises:

constructing a fourth expression for a real-time state of charge based on the output current, the battery capacity, and the initial state of charge of the independent variable, and

constructing the first expression based on the fourth expression and a relationship between the real-time state of charge and the open-circuit voltage.

17. The method according to claim 16, **characterized in that** the independent variable comprises the first resistor, and the constructing a second expression for an internal resistance voltage of the first internal resistance based on the independent variable comprises:

constructing the second expression based on the output current, the first resistor, and the fourth expression of the independent variable.

18. The method according to claim 15, **characterized in that** the independent variable comprises an output current, the first capacitor, and the second resistor of the battery module; and

the constructing a third expression for a parallel voltage of the parallel circuit based on the independent variable comprises:

constructing the third expression based on the output current, the first capacitor, and the second resistor among the independent variable.

19. The method according to any one of claims 1 to 18, **characterized in that** the identification result comprises a battery capacity of the battery module; and

the predicting a state of health of a battery in the battery module based on the identification result comprises:

predicting the state of health of the battery in the battery module based on a value of the battery capacity in the identification result.

20. An electronic device comprising a memory, a processor, and a computer program stored in the memory and capable of running on the processor, **characterized in that** when the computer program is executed by a processor, the battery state of health estimation method according to any one of claims 1 to 19 is implemented.

21. A computer-readable storage medium, the computer-readable storage medium storing a computer program, **characterized in that** when the computer program is executed by a processor, the battery state of health estimation method according to any one of claims 1 to 19 is implemented.

Obtain historical operating condition data of a to-be-tested battery module — 101

Perform parameter identification on a battery parameter of the battery module based on the historical operating condition data to obtain an identification result — 102

Predict a state of health of a battery in the battery module based on the identification result — 103

FIG. 1

Determine a dependent variable of a mathematical model based on a battery parameter — 201

Determine an independent variable related to the dependent variable based on the battery parameter — 202

Construct a mathematical model based on the independent variable and the dependent variable — 203

FIG. 2

FIG. 3

FIG. 4

| | |
|---|---|
| Discretize a mathematical model based on historical operating condition data to obtain a discretized mathematical model | 501 |
| Perform parameter identification on a battery parameter of a battery module based on the historical operating condition data and the discretized mathematical model to obtain an identification result | 502 |

FIG. 5

6

60

Memory

61

62

Processor

Computer program

Electronic device

FIG. 6

## INTERNATIONAL SEARCH REPORT

| International application No. |
| --- |
| **PCT/CN2024/071624** |

**A. CLASSIFICATION OF SUBJECT MATTER**

G01R31/392(2019.01)i; G01R31/36(2020.01)i

According to International Patent Classification (IPC) or to both national classification and IPC

**B. FIELDS SEARCHED**

Minimum documentation searched (classification system followed by classification symbols)

IPC:G01R31/-

Documentation searched other than minimum documentation to the extent that such documents are included in the fields searched

Electronic data base consulted during the international search (name of data base and, where practicable, search terms used)

CNTXT, ENTXTC, WPABSC, ENTXT, DWPI, WPABS, CJFD, Web of Science: 电池, 健康, 老化, 衰减, 参数辨识, 历史, 实际, 工况, 目标函数, battery, health, parameter identifica+, objective function?

**C. DOCUMENTS CONSIDERED TO BE RELEVANT**

| Category* | Citation of document, with indication, where appropriate, of the relevant passages | Relevant to claim No. |
| --- | --- | --- |
| X | CN 115389939 A (JIANGSU OLITER ENERGY TECHNOLOGY CO., LTD.) 25 November 2022 (2022-11-25) <br> description, paragraphs [0048]-[0089], and figures 1-4 | 1-5, 8, 9, 12-21 |
| Y | CN 115389939 A (JIANGSU OLITER ENERGY TECHNOLOGY CO., LTD.) 25 November 2022 (2022-11-25) <br> description, paragraphs [0048]-[0089], and figures 1-4 | 6, 7, 10, 11 |
| Y | CN 114740375 A (ZHEJIANG UNIVERSITY) 12 July 2022 (2022-07-12) <br> claims 1-4, description, paragraphs [0127]-[0133], and figure 1 | 6, 7, 10, 11 |
| A | CN 110133525 A (HARBIN INSTITUTE OF TECHNOLOGY) 16 August 2019 (2019-08-16) <br> entire document | 1-21 |
| A | CN 113419187 A (SHANGHAI JIAO TONG UNIVERSITY) 21 September 2021 (2021-09-21) <br> entire document | 1-21 |
| A | CN 115863805 A (STATE GRID TIANJIN ELECTRIC POWER COMPANY ELECTRIC POWER RESEARCH INSTITUTE et al.) 28 March 2023 (2023-03-28) <br> entire document | 1-21 |

☑ Further documents are listed in the continuation of Box C. ☑ See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **16 April 2024** | **19 April 2024** |

| Name and mailing address of the ISA/CN | Authorized officer |
| --- | --- |
| **China National Intellectual Property Administration (ISA/CN)** <br> **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT

| International application No. |
|---|
| **PCT/CN2024/071624** |

**C.     DOCUMENTS CONSIDERED TO BE RELEVANT**

| Category* | Citation of document, with indication, where appropriate, of the relevant passages | Relevant to claim No. |
|---|---|---|
| A | CN 116298921 A (ZHEJIANG NARADA ENERGY TECHNOLOGY CO., LTD. et al.) 23 June 2023 (2023-06-23)<br>    entire document | 1-21 |
| A | US 2014350877 A1 (NORTH CAROLINA STATE UNIVERSITY) 27 November 2014 (2014-11-27)<br>    entire document | 1-21 |
| A | CN 116256636 A (BYD CO., LTD. et al.) 13 June 2023 (2023-06-13)<br>    entire document | 1-21 |

Form PCT/ISA/210 (second sheet) (July 2022)

**INTERNATIONAL SEARCH REPORT**
Information on patent family members

International application No.

**PCT/CN2024/071624**

| Patent document cited in search report | | | Publication date (day/month/year) | Patent family member(s) | | | Publication date (day/month/year) |
|---|---|---|---|---|---|---|---|
| CN | 115389939 | A | 25 November 2022 | None | | | |
| CN | 114740375 | A | 12 July 2022 | None | | | |
| CN | 110133525 | A | 16 August 2019 | CN | 110133525 | B | 28 May 2021 |
| CN | 113419187 | A | 21 September 2021 | CN | 113419187 | B | 31 May 2022 |
| CN | 115863805 | A | 28 March 2023 | None | | | |
| CN | 116298921 | A | 23 June 2023 | None | | | |
| US | 2014350877 | A1 | 27 November 2014 | None | | | |
| CN | 116256636 | A | 13 June 2023 | None | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202310808644